# EUROPEAN PATENT SPECIFICATION

(11) **EP 1 562 206 B1**
(45) Date of publication and mention of the grant of the patent: **10.08.2011**
(21) Application number: 05100627.8
(22) Date of filing: 31.01.2005
(51) Int. Cl.: H01G 9/20

(54) **Dye-sensitized solar cell having enlarged wavelength range for light absorption and method of fabricating same**
Farbstoffsensibilisierte Solarzelle mit erweitertem Wellenlängenbereich und Hestellungsverfahren
Cellule solaire sensibilisée par un colorant ayant un domaine d'absorption étendu et procédé de fabrication

(30) Priority: 03.02.2004 KR 2004006930
(43) Date of publication of application: 10.08.2005
(73) Proprietor: Samsung SDI Co., Ltd., Suwon-si Gyeonggi-do (KR)
(72) Inventor: PARK, Joung-Won, Kyeonggi-Do (KR); LEE, Ji-Won, Kyeonggi-Do (KR); LEE, Wha-Sup, Kyeonggi-Do (KR); AHN, Kwang-Soon, Kyeonggi-Do (KR); CHOI, Jae-Man, Kyeonggi-Do (KR); SHIN, Byong-Cheol, Kyeonggi-Do (KR)
(74) Representative: Hengelhaupt, Jürgen

(56) References cited:
- EP-A- 1 231 619
- WO-A-94/04497
- WO-A1-94/05025
- PATENT ABSTRACTS OF JAPAN vol. 2003, no. 03, 5 May 2003 (2003-05-05) & JP 2002 343455 A (SHARP CORP), 29 November 2002 (2002-11-29)
- SAYAMA K ET AL: "Efficient sensitization of nanocrystalline TiO2 films with cyanine and merocyanine organic dyes" SOLAR ENERGY MATERIALS AND SOLAR CELLS, ELSEVIER SCIENCE PUBLISHERS, AMSTERDAM, NL, vol. 80, no. 1, 15 October 2003 (2003-10-15), pages 47-71, XP004456743 ISSN: 0927-0248
- AMADELLI R ET AL: "DESIGN OF ANTENNA-SENSITIZER POLYNUCLEAR COMPLEXES. SENSITIZATION OF TITANIUM DIOXIDE WITH ÚRU(BPY)2(CN)22RU(BPY(COO)2)22-" JOURNAL OF THE AMERICAN CHEMICAL SOCIETY, AMERICAN CHEMICAL SOCIETY, WASHINGTON, DC, US, vol. 112, no. 20, 26 September 1990 (1990-09-26), pages 7099-7103, XP000615434 ISSN: 0002-7863

## Description

### FIELD OF THE INVENTION

The present invention relates to a dye-sensitized solar cell and a method of fabricating the same, and in particular, to a dye-sensitized solar cell and a method of fabricating a dye-sensitized solar cell comprising a composite dye.

### BACKGROUND OF THE INVENTION

A dye-sensitized solar cell is a cell for converting solar energy into electric energy based on photosynthesis. Dye-sensitized solar cells involve relatively easy processing steps and low production cost, as compared to conventional silicon solar cells. As dye-sensitized solar cells are formed with transparent electrodes, they may be used in making windows for outer walls of buildings, or in making glass houses. Michael Gratzel of Ecole Polytechnique Federale de Lausanne (EPFL, Switzerland) conducted a prominent study concerning dye-sensitized solar cells in 1991.

A typical dye-sensitized solar cell has a first electrode with a dye-absorbed metallic oxide film, and a second electrode facing the first electrode and separated from the first electrode by a predetermined distance.

Dye-sensitized solar cells typically have low photoelectric conversion efficiency, and are therefore limited in their practical usage. To solve this problem, the sunlight absorption of the solar cell or the dye absorption thereof should be increased.

For this purpose, it has been conventionally proposed that the electrode reflectivity be heightened, that light scattering particles be used to increase sunlight absorption, or that the metallic oxide particles be dimensioned up to the nanometer level. However, such techniques are limited in enhancing the photoelectric conversion efficiency of the solar cell, and new technologies are needed to enhance the energy efficiency of the cell.

WO 94/05025 A1 discloses a photovoltaic cell comprising an electrically conductive element to which a TiO₂ layer has been applied. Photosensitizers are adsorbed at the surface of the TiO₂ layer.

Solar cells having dye sensitized nanocrystalline TiO₂ semiconductor electrodes have been described by Kazuhiro Sayama et al., Efficient sensitization of nanocrystalline TiO2 films with cyanine and merocyanine organic dyes, Solar Energy Materials & Solar Cells, Vol. 80, 2003, pages 47 - 71. For manufacturing of the electrodes small colloid TiO₂ particles (10 - 20 nm) and large TiO₂ particles (150 - 250 nm) are combined. Dyes are adsorbed on the TiO₂ surface.

JP 2002 343455 discloses a dye-sensitized solar cell having a porous semiconductor layer in which a composite dye formed by two or more dyes of different maximum light absorption wavelengths are adsorbed. A first dye may be a Ru bipyridine complex. According to an example a TiO₂ electrode composed of 30nm particles is prepared and ITO glass is used as a counter electrode.

Jinghuai Fang et al., The photovoltaic study of co-sensitized microporous TiO2 electrode with porphyrin and phthalocyanine molecules, Applied Surface Science, Vol. 119, 1997, pages 237 - 241, disclose solar cells having dye sensitized microporous TiO₂ electrodes including porphyrine and phthalocyanine dyes.

### SUMMARY OF THE INVENTION

The present invention provides a dye-sensitized solar cell which enlarges the effective wavelength range for light absorption to thereby enhance the photoelectric conversion efficiency of the solar cell.

Enlarged effective wavelength range for light absorption and enhanced photoelectric conversion efficiency is realized in a dye-sensitized solar cell with the following features.

According to one embodiment of the present invention, the dye-sensitized solar cell includes a first electrode comprising a light transmission material, and a second electrode facing the first electrode. A porous layer is formed on the first electrode, and a composite dye is absorbed to the porous layer, the composite dye comprising two or more dye materials. An electrolyte is impregnated between the first and second electrodes. The composite dye comprises Ru(2,2':6'-2"-terpyridine-4,4',4"-tricarboxylic acid)(NCS)₃ and Ru(4,4'-dicarboxy-2,2'-bipyridine)₂(CN)₂.

Ru(2,2':6'-2"-terpyridine-4,4',4"-tricarboxylic acid)(NCS)₃ may be present in the composite dye in an amount ranging from about 10 to about 80 mol%.

The porous layer comprises metallic oxide particles with a mean particle diameter of 100 nm or less. The mean particle diameter of the metallic oxide particles preferably ranges from about 10 to about 40 nm.

The porous layer further comprises conductive particles or light scattering particles. The light scattering particles are preferably formed from the same material as the metallic oxide particles of the porous layer, and have a mean particle diameter of 100 nm or more.

The first electrode comprises: a transparent substrate formed from a material selected from the group consisting of polyethylene terephthalate (PET), polyethylene naphthalate (PEN), polycarbonate (PC), polypropylene (PP), polyimide (Pl) and triacetate cellulose (TAC); and a conductive film coated on the substrate selected from the group consisting of indium tin oxide (ITO), fluorine tin oxide (FTO), ZnO-Ga₂O₃, ZnO-Al₂O₃ and SnO₂-Sb₂O₃.

The second electrode comprises: a transparent substrate formed from a material selected from the group consisting of polyethylene terephthalate (PET), polyethylene naphthalate (PEN), polycarbonate (PC), polypropylene (PP), polyimide (Pl) and triacetate cellulose (TAC); a first conductive film coated on the substrate selected from the group consisting of indium tin oxide (ITO), fluorine tin oxide (FTO), ZnO-Ga₂O₃, ZnO-Al₂O₃ and SnO₂-Sb₂O₃; and a second conductive film coated on the first conductive film, the second conductive film being selected from the group consisting of Pt and precious metals.

One method of fabricating a dye-sensitized solar cell comprises preparing first and second electrodes comprising light transmission materials. A porous layer is then formed on a surface of the first electrode. A composite dye comprising Ru(2,2':6'-2"-terpyridine-4,4',4"-tricarboxylic acid)(NCS)₃ and Ru(4,4'-dicarboxy-2,2'-bipyridine)₂(CN)₂ is prepared and absorbed into the porous layer. The first and second electrodes are arranged such that the porous layer of the first electrode faces the second electrode. An electrolyte is then impregnated between the first and second electrodes, and sealed.

Ru(2,2':6'-2"-terpyridine-4,4',4"-tricarboxylic acid)(NCS)₃ may be present in the composite dye in an amount ranging from about 10 to about 80 mol%.

The composite dye is prepared by dissolving Ru(2,2':6'-2"-terpyridine-4,4',4"-tricarboxylic acid)(NCS)₃ in alcohol to a concentration of 0.1 ~ 5 mM, and adding another dye material to the alcohol.

### BRIEF DESCRIPTION OF THE DRAWINGS

The above and other advantages of the present invention will become more apparent by describing preferred embodiments thereof in detail with reference to the accompanying drawings in which:

FIG. 1 is a representational cross sectional view of a dye-sensitized solar cell according to an embodiment of the present invention;

FIG. 2 is a graphical comparison of the relationship between the degree of light absorption and the wavelength of a dye-sensitized solar cell according to the prior art with that of a dye-sensitized solar cell according to an embodiment of the present invention;

FIG. 3 is a graphical comparison of the relationship between the voltage and current density of a dye-sensitized solar cell according to Comparative Examples 1 and 2, and Example 1; and

FIG. 4 is a graphical comparison of the incident photon-to-current conversion efficiency (IPCE) of dye-sensitized solar cells according to Comparative Examples 1 and 2, and Example 1.

### DETAILED DESCRIPTION

The present invention will be described more fully hereinafter with reference to the accompanying drawings, in which alternative embodiments of the invention are shown.

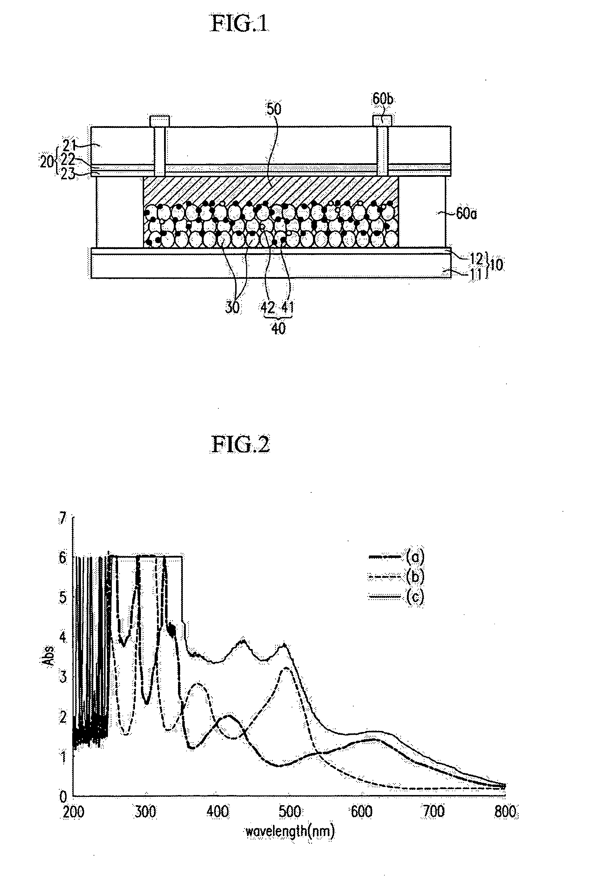

FIG. 1 is a representational cross sectional view of a dye-sensitized solar cell according to an embodiment of the present invention.

As shown in FIG. 1, the dye-sensitized solar cell comprises a first electrode 10 comprising a light transmission material, and a second electrode 20 facing the first electrode 10 and separated from the first electrode 10 by a predetermined distance. A porous layer 30 is formed on the surface of the first electrode 10, and faces the second electrode 20. A composite dye 40 is absorbed to the porous layer 30. The space between the first and the second electrodes 10 and 20 is filled with an electrolyte 50.

The first electrode 10 comprises a transparent substrate 11, and a conductive film 12 coated on the substrate 11. The substrate 11 is selected from the group consisting of polyethylene terephthalate ("PET"), polyethylene naphthalate ("PEN"), polycarbonate ("PC"), polypropylene ("PP"), polyimide ("PI"), triacetate cellulose ("TAC"), and combinations thereof. The conductive film 12 is selected from the group consisting of indium tin oxide ("ITO"), fluorine tin oxide ("FTO"), ZnO-Ga₂O₃, ZnO-Al₂O₃, SnO₂-Sb₂O₃, and combinations thereof.

The porous layer 30 is formed on the surface of the first electrode 10 and faces the second electrode 20. The porous layer 30 contains metallic oxide particles having nanometer-level mean particle diameters. Nonlimiting examples of particles suitable for use in the porous layer are TiO₂ particles. The metallic oxide particles of the porous layer 30 preferably have equal particle diameters such that the porous layer 30 can bear a high porosity and an optimal surface roughness.

The metallic oxide particles of the porous layer 30 have mean particle diameters of 100 nm or less, preferably 10 ~ 40 nm. Based on the particle diameters of a TiO₂-based porous layer, when the mean particle diameter of the metallic oxide particles is less than 10 nm, the adhesive force is too weak to form a stable porous layer. When the mean particle diameter of the metallic oxide particles exceeds 40 nm, the surface area of the dye-absorbed porous layer 30 is reduced, thereby reducing photoelectric conversion efficiency.

The porous layer 30 is formed by coating an oxide paste onto the inner surface of the first electrode 10, and heat-treating the paste.

A doctor blade or screen-printing technique is used to coat the paste onto the first electrode 10. Spin coating or spraying may be used to form the porous layer 30 on the transparent material of the first electrode 10. A common wet coating technique can also be used. The physical properties of the paste differ depending on the coating technique used.

When a binder is added to the paste, the paste is heat-treated at 450 - 600°C for 30 minutes. In the absence of such a binder, the paste can be heat-treated at a temperature of 200°C or cooler.

The paste for forming the porous layer 30 further comprises a polymer to maintain the porosity of the porous layer 30. The polymer is preferably one which will not leave any organic material after heat treatment. Nonlimiting examples of suitable polymers include polyethylene glycol ("PEG"), polyethylene oxide ("PEO"), polyvinyl alcohol ("PVA"), and polyvinyl pyrrolidone ("PVP"). Polymer selection may vary depending on the coating technique used. A polymer with the proper molecular weight based on the coating technique is selected and then added to the porous layer 30. When the polymer is added to the paste for forming the porous layer 30, the porosity of the porous layer is increased, and the diffusivity and viscosity of the porous layer 30 are also increased, thereby enhancing film formation and adhesive force of the film to the substrate.

And, the porous layer 30 further comprises conductive particles or light scattering particles. The conductive particles facilitate easy migration of electrons, and comprise ITO. The light scattering particles enlarge the optical path length and enhance photoelectric conversion efficiency. The light scattering particles comprise the same material as the metallic oxide of the porous layer, and have mean particle diameters of 100 nm or more.

A composite dye 40, comprising two or more dye materials, is absorbed to the metallic oxide particles of the porous layer 30. The dye 40 comprises two or more dye materials having different wavelength regions for absorption in order to enlarge the effective wavelength range for light absorption. The dye materials are capable of absorbing visible rays. Ruthenium (Ru) is an element in the platinum group which is capable of forming a number of organic metal complex compounds.

Organic pigments may also be used as components of the composite dye used in the dye-sensitized solar cells of the present invention. The organic pigment is selected from the group consisting of coumarin, porphyrin, xanthene, riboflavin, triphenylmethane, and combinations thereof. The organic pigment may be used by itself, or in combination with the Ru complex. The organic pigment is cost effective, abundant and readily available. Furthermore, the organic pigment improves absorption of the long-wavelength visible ray parts, and enhances cell energy efficiency.

In order to naturally absorb the dye 40 to the porous layer 30, the first electrode 10 coated with the porous layer 30 is dipped in an alcoholic solution containing the dye materials for about 12 hours.

As shown in FIG. 1, the composite dye 40 is formed with a mixture of a first dye material 41 and a second dye material 42. However, the composite dye 40 is not limited thereto, and may contain other materials.

The first and second dye materials 41 and 42, respectively, are formed with Ru complexes having different ligands. The first dye material 41 is Ru(2,2':6'-2"-terpyridine-4,4',4"-tricarboxylic acid)(NCS)₃. To enhance long wavelength energy absorption, the first dye material 41 is present in the composite dye 40 in an amount ranging from about 10 to about 80 mol%.

The second dye material 42 is Ru(4,4'-dicarboxy-2,2'-bipyridine) ₂(CN)₂.

The second electrode 20 faces the first electrode 10, and has a transparent substrate 21 and a first conductive film 22 coated on the substrate 21. The second electrode 20 may further comprise a second conductive film 23 coated on the first conductive film 22. The substrate 21 comprises a material selected from the group consisting of PET, PEN, PC, PP, PI and TAC, and the first conductive film 22 comprises a material selected from the group consisting of ITO, FTO, ZnO-Ga₂O₃, ZnO-Al₂O₃ and SnO₂-Sb₂O₃. The second conductive film 23 comprises a material selected from the group consisting of Pt and precious metals.

To make the second conductive film 23 comprising Pt, a solution that H₂PtCl₆ is dissolved in an organic solvent selected from the group consisting of MeOH, EtOH and IPA (isopropyl alcohol), is wet-coated onto the first conductive film 22 by spin coating, dip coating or flow coating, and heat-treated at a temperature of 400°C or higher under an air or oxygen atmosphere. Alternatively, physical vapor deposition (PVD) such as electrolyte plating, sputtering or electron beam deposition may be used.

The electrolyte 50 is impregnated between the first and second electrodes 10 and 20, and uniformly diffused into the inside of the porous layer 30. The electrolyte 50 comprises iodide and triiodide, receives electrons from the second electrode 20 and transfers them to the dye 40 through oxidation and reduction. The voltage of the solar cell is determined by the energy level of the dye and the difference between the levels of oxidation and reduction of the electrolyte 50.

In one embodiment of a solar cell according to the present invention, the first and the second electrodes 10 and 20, are attached to each other by an adhesive 60a. The second electrode 20 is penetrated to form a small hole. A solution for forming the electrolyte 50 is injected into the space between the two electrodes via the hole, which is then externally sealed using an adhesive 60b.

The adhesives 60a and 60b may each comprise a thermoplastic polymer film, such as SURLYN™. The thermoplastic polymer film is disposed between the two electrodes, and thermally pressed. An epoxy resin or ultraviolet (UV) hardening agent may be used to form the adhesives 60a and 60b, in which case the adhesive is hardened after heat treatment or UV treatment.

When sunlight is incident upon the solar cell, the photons are first absorbed into the dye molecules, and the dye molecules are excited from the ground state to the excited state through electron transfer to make electron-hole pairs. The excited electrons are introduced into the conduction band of the transition metal oxide forming the porous layer, transported to the external circuit via the first electrode, and the electrons then migrate to the counter electrode. The iodide (I⁻) within the electrolyte is oxidized to triiodide (I₃⁻), thereby reducing the oxidized dye. The triiodide (I₃⁻) reacts with the electrons that migrated to the second electrode, and is reduced to iodide (I⁻). Thus, the migration of electrons operates the solar cell.

According to the present invention, the composite dye comprises a mixture of two or more dye materials having different wavelength ranges, thereby increasing the long-wavelength energy absorption of the visible rays. This will be explained with reference to FIG. 2.

FIG. 2 compares the light absorption degree (Abs) as a function of wavelength of a dye-sensitized solar cell according to the prior art to that of a dye-sensitized solar cell according to one embodiment of the present invention. FIG. 2 graphs: (a) a dye-sensitized solar cell using a single dye comprising Ru(2,2':6'-2"-terpyridine-4,4',4"-tricarboxylic acid)(NCS)₃, (b) a dye-sensitized solar cell using a single dye comprising Ru(4,4'-dicarboxy-2,2'-bipyridine) ₂(CN)₂, and (c) a dye-sensitized solar cell using a composite dye comprising a mixture of Ru(2,2':6'-2"-terpyridine-4,4',4"-tricarboxylic acid)(NCS)₃ and Ru(4,4'-dicarboxy-2,2'-bipyridine) ₂(CN)₂.

As shown in FIG. 2, the wavelength range for light absorption of the solar cell using the composite dye, shown as line (c), is larger than that of the solar cells using the single dyes Ru(2,2':6'-2"-terpyridine-4,4',4"-tricarboxylic acid)(NCS)₃ and Ru(4,4'-dicarboxy-2,2'-bipyridine) ₂ (CN)₂, shown as lines (a) and (b), respectively.

During the first step of operating a dye-sensitized solar cell, the dye molecules generate photo-charges from light energy. Accordingly, to enhance the energy efficiency of the dye-sensitized solar cell, the effective light energy absorption of the dye molecules should be increased or the effective wavelength range for light absorption should be enlarged.

According to the present invention, the effective wavelength range for light energy absorption is enlarged by using a mixture of Ru(2,2':6'-2"-terpyridine-4,4',4"-tricarboxylic acid)(NCS)₃ and Ru(4,4'-dicarboxy-2,2'-bipyridine) ₂(CN)₂.

In a method of fabricating a dye-sensitized solar cell according to the present invention, first and second electrodes comprising light transmission materials are prepared, and a porous layer is formed on a surface of the first electrode. Ru(2,2':6'-2"-terpyridine-4,4',4"-tricarboxylic acid)(NCS)₃ and Ru(4,4'-dicarboxy-2,2'-bipyridine) ₂(CN)₂ are mixed to form a composite dye, and the composite dye is absorbed to the porous layer. Thereafter, the first and second electrodes are arranged such that the porous layer of the first electrode faces the second electrode. An electrolyte is injected between the first and second electrodes and sealed, thereby fabricating a dye-sensitized solar cell.

According to one method of preparing the composite dye, Ru(2,2':6'-2"-terpyridine-4,4',4"-tricarboxylic acid)(NCS)₃ is dissolved in a solvent, such as alcohol, and Ru(4,4'-dicarboxy-2,2'-bipyridine)₂(CN)₂, is added thereto.

It is preferable that Ru(2,2':6'-2"-terpyridine-4,4',4"-tricarboxylic acid)(NCS)₃ is dissolved in an alcohol to a concentration ranging from about 0.1 to about 5mM, and another dye material is added thereto.

In this case, Ru(2,2':6'-2"-terpyridine-4,4',4"-tricarboxylic acid)(NCS)₃ is present in the composite dye in an amount ranging from about 10 to about 80 mol%.

One example of the present invention will now be explained.

### Example 1

An ITO-based film was coated on a transparent substrate to form a first electrode. A dispersed solution of TiO₂ particles having a mean particle diameter of 5 ~ 15 nm was coated onto a 1 cm² ITO-based film using a doctor blade technique, and fired at 450°C for 30 minutes to form a porous layer with a thickness of about 3 µm.

Thereafter, 0.3 mM Ru(4,4'-dicarboxy-2,2'-bipyridine)₂(CN)₂ and 0.45 mM Ru(2,2':6'-2"-terpyridine-4,4',4"-tricarboxylic acid)(NCS)₃ were dissolved in ethanol to form a dye solution, and the first electrode with the porous layer was dipped in the dye solution at 80°C for 12 hours or more such that the dye absorbed to the porous layer. The dye-absorbed porous titanium oxide film was then cleaned using ethanol, and dried at ambient temperature.

ITO and Pt-based films were coated on a transparent substrate to form a second electrode. A 0.75 mm diameter hole for injecting an electrolyte was formed at the second electrode using a drill.

The Pt-based film of the second electrode was positioned facing the porous layer on the first electrode, and a thermoplastic polymer film with a thickness of 60 µm was placed between the first and second electrodes. The first and second electrodes were pressed at 100°C for nine seconds to attach them to each other. An electrolyte was injected between the two electrodes through the hole formed at the second electrode, and the hole was sealed using a cover glass and thermoplastic polymer film, thereby making a dye-sensitized solar cell. The electrolyte was prepared by dissolving 0.62 M 1,2-dimethyl-3-hexylimidazolium iodide, 0.5 M 2-aminopyrimidine, 0.1 M lithium iodide (Lil) and 0.05 M I₂ in an acetonitrile solvent.

### Comparative Example 1

An ITO-based film was coated on a transparent substrate to form a first electrode. A dispersed solution of TiO₂ particles having a mean particle diameter of 5 - 15 nm was coated onto a 1 cm² ITO-based film using a doctor blade technique, and fired at 450°C for 30 minutes to thereby form a porous layer with a thickness of about 3 µm.

Thereafter, 0.45 mM Ru(2,2':6'-2"-terpyridine-4,4',4"-tricarboxylic acid)(NCS)₃ was dissolved in ethanol to form a dye solution, and the first electrode with the porous layer was dipped in the dye solution at 80°C for 12 hours or more such that the dye was absorbed into the porous layer. The dye-absorbed porous titanium oxide film was then cleaned using ethanol, and dried at ambient temperature.

ITO and Pt-based films were coated on a transparent substrate to form a second electrode. A 0.75 mm diameter hole for injecting an electrolyte was formed at the second electrode using a drill.

The Pt-based film of the second electrode was positioned facing the porous layer of the first electrode, and a thermoplastic polymer film with a thickness of 60 µm was placed between the first and second electrodes. The first and second electrodes were pressed at 100°C for nine seconds to attach them to each other. An electrolyte was injected between the two electrodes through the hole formed at the second electrode, and the hole was sealed using a cover glass and thermoplastic polymer film, thereby making a dye-sensitized solar cell. The electrolyte was prepared by dissolving 0.62 M 1,2-dimethyl-3-hexylimidazolium iodide, 0.5 M 2-aminopyrimidine, 0.1 M lithium iodide (Lil) and 0.05 M I₂ in an acetonitrile solvent.

### Comparative Example 2

An ITO-based film was coated on a transparent substrate to form a first electrode. A dispersed solution of TiO₂ particles having a mean particle diameter of 5 - 15 nm was coated onto a 1cm² ITO-based film using a doctor blade technique, and fired at 450°C for 30 minutes to thereby form a porous layer with a thickness of about 3 µm.

Thereafter, 0.3 mM Ru(4,4'-dicarboxy-2,2'-bipyridine)₂(CN)₂ was dissolved in ethanol to form a dye solution, and the first electrode with the porous layer was dipped in the dye solution at 80°C for 12 hours or more such that the dye was absorbed into the porous layer. The dye-absorbed porous titanium oxide film was then cleaned using ethanol, and dried at ambient temperature.

ITO and Pt-based films were coated on a transparent substrate to form a second electrode. A 0.75 mm diameter hole for injecting an electrolyte was formed at the second electrode using a drill.

The Pt-based film of the second electrode was positioned facing the porous layer of the first electrode, and a thermoplastic polymer film with a thickness of 60 µm was placed between the first and second electrodes. The first and second electrodes were pressed at 100°C for nine seconds to attach them to each other. An electrolyte was injected between the two electrodes through the hole formed at the second electrode, and the hole was sealed using a cover glass and thermoplastic polymer film, thereby making a dye-sensitized solar cell. The electrolyte was prepared by dissolving 0.62 M 1,2-dimethyl-3-hexylimidazolium iodide, 0.5 M 2-aminopyrimidine, 0.1 M lithium iodide (Lil) and 0.05 M I₂ in an acetonitrile solvent.

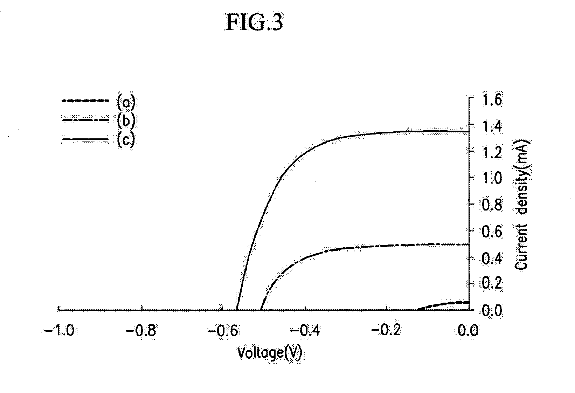

FIG. 3 illustrates the relationship between the voltage and current density of dye-sensitized solar cells prepared according to Comparative Examples 1 and 2, and Example 1. FIG. 3 graphs: (a) the voltage-current density curve of the dye-sensitized solar cell prepared according to Comparative Example 1, (b) the voltage-current density curve of the dye-sensitized solar cell prepared according to Comparative Example 2, and (c) the voltage-current density curve of the dye-sensitized solar cell prepared according to Example 1. Voltage and current density were measured using a standard Si cell with a light source of 100 mW/cm².

The energy efficiency, open circuit voltage, short circuit current, and fill factor (FF) of the dye-sensitized solar cells according to Example 1 and Comparative Examples 1 and 2 were determined from the corresponding voltage-current density curves.

The dye-sensitized solar cell according to Example 1 exhibited 0.48% energy efficiency, 0.567 V open circuit voltage, 1.34 mA/cm² short circuit current, and a 0.63 fill factor. By contrast, the dye-sensitized solar cell according to Comparative Example 1 exhibited 0.0002% energy efficiency, 0.093 V open circuit voltage, 0.01 mA/cm² short circuit current, and a 0.30 fill factor. The dye-sensitized solar cell according to Comparative Example 2 exhibited 0.16% energy efficiency, 0.505 V open circuit voltage, 0.49 mA/cm² short circuit current, and a 0.65 fill factor.

These results show that the dye-sensitized solar cell prepared according to Example 1 has higher energy efficiency than that of the dye-sensitized solar cells according to both Comparative Examples 1 and 2. Particularly, the open circuit voltage and short circuit current of the cell prepared according to Example 1 are higher than those of the cells prepared according to Comparative Examples 1 and 2.

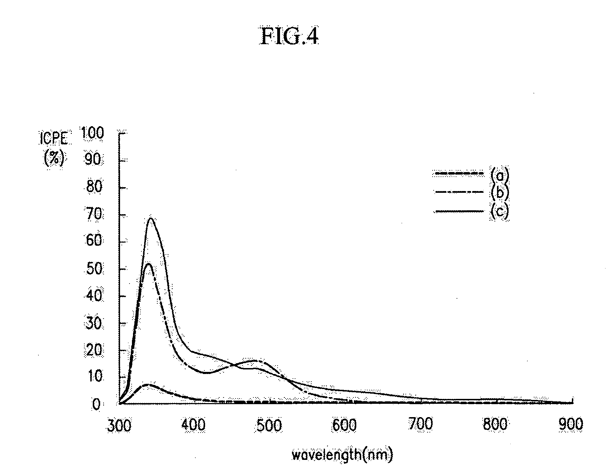

FIG. 4 illustrates the incident photon-to-current conversion efficiency (IPCE) of dye-sensitized solar cells prepared according to Comparative Examples 1 and 2, and Example 1.

FIG. 4 graphs: (a) the IPCE of a dye-sensitized solar cell prepared according to Comparative Example 1, (b) the IPCE of a dye-sensitized solar cell prepared according to Comparative Example 2, and (c) the IPCE of a dye-sensitized solar cell according to Example 1.

As shown in FIG. 4, the IPCE of the dye-sensitized solar cell prepared according to Example 1 (using a composite dye) is higher than that of the dye-sensitized solar cells prepared according to Comparative Examples 1 and 2 (using a single dye).

As described above, the effective wavelength range for light energy absorption of the dye-sensitized solar cell according to the present invention is enlarged by using a composite dye including a mixture of Ru(2,2':6'-2"-terpyridine-4,4',4"-tricarboxylic acid)(NCS)₃ and Ru(4,4'-dicarboxy-2,2'-bipyridine) ₂(CN)₂. Consequently, the energy efficiency of the dye-sensitized solar cell is enhanced.

## Claims

1. A dye-sensitized solar cell comprising:
a first electrode (10) comprising a light transmission material;
a porous layer (30) formed on a surface of the first electrode (10);
a composite dye (40) absorbed to the porous layer (30), the composite dye (40) comprising two or more dye materials (41, 42);
a second electrode (20) facing the porous layer (30) on the first electrode (10); and
an electrolyte (50) impregnated between the first and second electrodes (10, 20),
**characterized in that** the composite dye (40) comprises Ru(2,2':6'-2"-terpyridine-4,4',4"-tricarboxylic acid)(NCS)₃and Ru(4,4'-dicarboxy-2,2'-bipyridine)₂(CN)₂.

2. The dye-sensitized solar cell of claim 1, wherein Ru(2,2':6'-2"-terpyridine-4,4',4"-tricarboxylic acid)(NCS)₃ is present in the composite dye (40) in an amount ranging from about 10 to about 80 mol%.

3. The dye-sensitized solar cell of claim 1, wherein the porous layer (30) comprises a plurality of metallic oxide particles having a mean particle diameter of 100 nm or less.

4. The dye-sensitized solar cell of claim 3, wherein the mean particle diameter of the metallic oxide particles is 10 ~ 40 nm.

5. The dye-sensitized solar cell of claim 3, wherein the porous layer (30) further comprises a plurality of particles selected from the group consisting of conductive particles and light scattering particles.

6. The dye-sensitized solar cell of claim 3, wherein the porous layer (30) further comprises a plurality of light scattering particles, and the light scattering particles comprise the same material as the metallic oxide particles of the porous layer, the light scattering particles having a mean particle diameter of 100 nm or more.

7. The dye-sensitized solar cell of claim 1, wherein the first electrode (10) comprises: a transparent substrate selected from the group consisting of polyethylene terephthalate (PET), polyethylene naphthalate (PEN), polycarbonate (PC), polypropylene (PP), polyimide (PI) and triacetate cellulose (TAC); and a conductive film coated on the substrate, the conductive film selected from the group consisting of indium tin oxide (ITO), fluorine tin oxide (FTO), ZnO-Ga₂O₃, ZnO-Al₂O₃ and SnO₂-Sb₂O₃.

8. The dye-sensitized solar cell of claim 1, wherein the second electrode (20) comprises: a transparent substrate selected from the group consisting of polyethylene terephthalate (PET), polyethylene naphthalate (PEN), polycarbonate (PC), polypropylene (PP), polyimide (PI) and triacetate cellulose (TAC); a first conductive film coated on the substrate, the first conductive film selected from the group consisting of indium tin oxide (ITO), fluorine tin oxide (FTO), ZnO-Ga₂O₃, ZnO-Al₂O₃ and SnO₂-Sb₂O₃; and a second conductive film coated on the first conductive film, the second conductive film selected from the group consisting of Pt and precious metals.

9. The dye-sensitized solar cell according to claim 1, wherein the dye materials of the composite dye (40) comprises an organic pigment.

10. The dye-sensitized solar cell according to claim 9, wherein the organic pigment is selected from the group consisting of coumarin, porphyrin, xanthene, riboflavin and triphenylmethane.

11. A method of fabricating a dye-sensitized solar cell comprising:
preparing first and second electrodes (10, 20), each electrode comprising a light transmission material;
forming a porous layer (30) on a surface of the first electrode (10);
preparing a composite dye (40) comprising Ru(2,2':6'-2"-terpyridine-4,4',4"-tricarboxylic acid)(NCS)₃ and Ru(4,4'-dicarboxy-2,2'-bipyridine)₂(CN)₂;
absorbing the composite dye (40) to the porous layer (30);
positioning the second electrode (20) facing the porous layer (40) on the first electrode (10);
impregnating an electrolyte (50) between the first and second electrodes (10, 20); and
attaching the first and second electrodes (10, 20) to each other.

12. The method of claim 11, wherein wherein the Ru(2,2':6'-2"-terpyridine-4,4',4"-tricarboxylic acid)(NCS)₃ is present in the composite dye in an amount ranging from about 10 to about 80 mol%.

13. The method of claim 11, wherein the preparing a composite dye (40) step comprises dissolving Ru(2,2':6'-2"-terpyridine-4,4',4"-tricarboxylic acid)(NCS)₃ in alcohol to a concentration ranging from about 0.1 to about 5 mM, and then adding a different dye material to the alcohol.

## Patentansprüche

1. Farbstoffsensibilisierte Solarzelle mit:
einer ersten Elektrode (10), die ein lichtdurchlässiges Material aufweist;
einer porösen Schicht (30), die auf einer Oberfläche der ersten Elektrode (10) gebildet ist;
ein Mischfarbstoff (40), der in die poröse Schicht (30) absorbiert wird, wobei der Mischfarbstoff (40) zwei oder mehr Farbstoffe (41, 42) aufweist;
einer zweiten Elektrode (20), die der porösen Schicht (30) auf der ersten Elektrode (10) zugewandt ist; und
einem zwischen der ersten und zweiten Elektrode (10, 20) getränktem Elektrolyten (50),
**dadurch gekennzeichnet, dass** der Mischfarbstoff (40) Ru(2,2':6'-2"-terpyridin-4,4',4"-tricarboxylsäure)(NCS)₃ und Ru(4,4'-dicarboxy-2,2'-bipyridin)₂(CN)₂ enthält.

2. Farbstoffsensibilisierte Solarzelle nach Anspruch 1, wobei Ru(2,2':6'-2"-terpyridin-4,4',4"-tricarboxylsäure)(NCS)₃ in dem Mischfarbstoff (40) in einer Menge zwischen ca. 10 bis ca. 80 Mol-% vorhanden ist.

3. Farbstoffsensibilisierte Solarzelle nach Anspruch 1, wobei die poröse Schicht (30) eine Vielzahl von Metalloxidpartikeln umfasst, die einen mittleren Partikeldurchmesser von 100 nm oder weniger besitzen.

4. Farbstoffsensibilisierte Solarzelle nach Anspruch 3, wobei der durchschnittliche Partikeldurchmesser der Metalloxidpartikel 10 ∼ 40 nm beträgt.

5. Farbstoffsensibilisierte Solarzelle nach Anspruch 3, wobei die poröse Schicht (30) weiterhin eine Vielzahl von Partikeln aufweist, die aus der Gruppe von leitenden Partikeln und lichtstreuenden Partikeln ausgewählt sind.

6. Farbstoffsensibilisierte Solarzelle nach Anspruch 3, wobei die poröse Schicht (30) weiterhin eine Vielzahl von lichtstreuenden Partikeln aufweist, und die lichtstreuenden Partikel das gleiche Material wie die Metalloxidpartikel der porösen Schicht umfassen, wobei die lichtstreuenden Partikel einen mittleren Partikeldurchmesser von 100 nm oder mehr besitzen.

7. Farbstoffsensibilisierte Solarzelle nach Anspruch 1, wobei die erste Elektrode (10) folgendes besitzt: ein transparentes Substrat, das aus der Gruppe von Polyethylenterephthalat (PET), Polyethylennaphthalat (PEN), Polycarbonat (PC), Polypropylen (PP), Polyimid (PI) und Triacetat-Cellulose (TAC) ausgewählt ist; und eine leitfähige Schicht, mit der das Substrat überzogen ist, wobei die leitfähige Schicht aus der Gruppe von Indium-Zinnoxid (ITO), Fluor-Zinnoxid (FTO), ZnO-Ga₂O₃, ZnO-Al₂O₃ und SnO₂-Sb₂O₃ ausgewählt ist.

8. Farbstoffsensibilisierte Solarzelle nach Anspruch 1, wobei die zweite Elektrode (20) folgendes besitzt: ein transparentes Substrat, das aus der Gruppe von Polyethylenterephthalat (PET), Polyethylennaphthalat (PEN), Polycarbonat (PC), Polypropylen (PP), Polyimid (PI) und Triacetat-Cellulose (TAC) ausgewählt ist; eine erste leitfähige Schicht, mit der das Substrat überzogen ist, wobei die erste leitfähige Schicht aus der Gruppe von Indium-Zinnoxid (ITO), Fluor-Zinnoxid (FTO), ZnO-Ga₂O₃, ZnO-Al₂O₃ und SnO₂-Sb₂O₃ ausgewählt ist; und eine zweite leitfähige Schicht, mit der die erste leitfähige Schicht überzogen ist, wobei die zweite leitfähige Schicht aus der Gruppe von Pt und Edelmetallen ausgewählt ist.

9. Farbstoffsensibilisierte Solarzelle nach Anspruch 1, wobei die Farbstoffmaterialien des Mischfarbstoffes (40) ein organisches Pigment aufweisen.

10. Farbstoffsensibilisierte Solarzelle nach Anspruch 9, wobei das organische Pigment aus der Gruppe von Kumarin, Porphyrin, Xanthen, Riboflavin und Triphenylmethan ausgewählt ist.

11. Herstellungsverfahren für eine farbstoffsensibilisierte Solarzelle, das folgendes umfasst:
Bereitstellen erster und zweiter Elektroden (10, 20), wobei jede Elektrode ein lichtdurchlässiges Material aufweist;
Herstellen einer porösen Schicht (30) auf einer Oberfläche der ersten Elektrode (10);
Bereitstellen eines Mischfarbstoffes (40) mit Ru(2,2':6'-2"-terpyridin-4,4',4"-tricarboxylsäure)(NCS)₃ und Ru(4,4'-dicarboxy-2,2'-bipyridin)₂(CN)₂;
Absorbieren des Mischfarbstoffes (40) in die poröse Schicht (30);
Positionieren der zweiten Elektrode (20), die der porösen Schicht (30) zugewandt ist, an der ersten Elektrode (10);
Tränken eines Elektrolyten (50) zwischen den ersten und zweiten Elektroden (10, 20); und
Befestigen der ersten und zweiten Elektroden (10, 20) aneinander.

12. Verfahren nach Anspruch 11, wobei Ru(2,2':6'-2"-terpyridin-4,4',4"-tricarboxylsäure)(NCS)₃ in dem Mischfarbstoff (40) in einer Menge zwischen ca. 10 bis ca. 80 Mol-% vorhanden ist.

13. Verfahren nach Anspruch 11, wobei der Schritt der Bereitstellung eines Mischfarbstoffes (40) das Auflösen von Ru(2,2':6'-2"-terpyridin-4,4',4"-tricarboxylsäure)(NCS)₃ in Alkohol auf eine Konzentration zwischen ca. 0,1 bis ca. 5 mM und das anschließende Hinzufügen eines anderen Farbstoffes zu dem Alkohol umfasst.

## Revendications

1. Cellule solaire sensibilisée avec un colorant, comprenant :
une première électrode (10) comprenant une matière transmettant la lumière ;
une couche poreuse (30) formée sur une surface de la première électrode (10) ;
un colorant composite (40) absorbé par la couche poreuse (30), le colorant composite (40) comprenant deux ou plus de deux matières colorantes (41, 42) ;
une seconde électrode (20) tournée vers la couche poreuse (30) sur la première électrode (10) ; et
un électrolyte (50) à l'état imprégné entre les première et seconde électrodes (10, 20),
**caractérisée en**tre ce que le colorant composite (40) comprenant du Ru(acide 2,2':6'-2''-terpyridine-4,4',4''-tricarboxylique)(NCS)₃ et du Ru(4,4'-dicarboxy-2,2'-bipyridine)₂(CN)₂.

2. Cellule solaire sensibilisée avec un colorant suivant la revendication 1, dans laquelle le Ru(acide 2,2':6'-2''-terpyridine-4,4',4"-tricarboxylique)(NCS)₃ est présent dans le colorant composite (40) en une quantité allant d'environ 10 à environ 80 % en moles.

3. Cellule solaire sensibilisée avec un colorant suivant la revendication 1, dans laquelle la couche poreuse (30) comprend une pluralité de particules d'oxyde métallique ayant un diamètre moyen de particule égal ou inférieur à 100 nm.

4. Cellule solaire sensibilisée avec un colorant suivant la revendication 3, dans laquelle le diamètre moyen de particule des particules d'oxyde métallique est d'approximativement 10 à 40 nm.

5. Cellule solaire sensibilisée avec un colorant suivant la revendication 3, dans laquelle la couche poreuse (30) comprend en outre une pluralité de particules choisies dans le groupe consistant en des particules conductrices et des particules diffusant la lumière.

6. Cellule solaire sensibilisée avec un colorant suivant la revendication 3, dans laquelle la couche poreuse (30) comprend en outre une pluralité de particules diffusant la lumière, et les particules diffusant la lumière comprennent la même matière que les particules d'oxyde métallique de la couche poreuse, les particules diffusant la lumière ayant un diamètre moyen de particule égal ou supérieur à 100 nm.

7. Cellule solaire sensibilisée avec un colorant suivant la revendication 1, dans laquelle la première électrode (10) comprend : un substrat transparent choisi dans le groupe consistant en poly(téréphtalate d'éthylène) (PET), polynaphtalate d'éthylène (PEN), polycarbonate (PC), polypropylène (PP), polyimide (PI) et triacétate de cellulose (TAC) ; et un film conducteur sous forme d'un revêtement sur le substrat, le film conducteur étant choisi dans le groupe consistant en oxyde d'indium-étain (ITO), fluor-oxyde d'étain (FTO), ZnO-Ga₂O₃, ZnO-Al₂O₃ et SnO₂-Sb₂O₃.

8. Cellule solaire sensibilisée avec un colorant suivant la revendication 1, dans laquelle la seconde électrode (20) comprend : un substrat transparent choisi dans le groupe consistant en poly(téréphtalate d'éthylène) (PET), polynaphtalate d'éthylène (PEN), polycarbonate (PC), polypropylène (PP), polyimide (PI) et triacétate de cellulose (TAC) ; un premier film conducteur sous forme d'un revêtement sur le substrat, le premier film conducteur étant choisi dans le groupe consistant en oxyde d'indium-étain (ITO), fluor-oxyde d'étain (FTO), ZnO-Ga₂O₃, ZnO-Al₂O₃ et SnO₂-Sb₂O₃ ; et un second film conducteur sous forme de revêtement sur le premier film conducteur, le second film conducteur étant choisi dans le groupe consistant en Pt et en métaux précieux.

9. Cellule solaire sensibilisée avec un colorant suivant la revendication 1, dans laquelle les matières colorantes du colorant composite (40) comprennent un pigment organique.

10. Cellule solaire sensibilisée avec un colorant suivant la revendication 9, dans laquelle le pigment organique est choisi dans le groupe consistant en coumarine, porphyrine, xanthène, riboflavine et triphényl-méthane.

11. Procédé de fabrication d'une cellule solaire sensibilisée avec un colorant, comprenant :
la préparation de première et seconde électrodes (10, 20), chaque électrode comprenant une matière transmettant la lumière ;
la formation d'une couche poreuse (30) sur une surface de la première électrode (10) ;
la préparation d'un colorant composite (40) comprenant du Ru(acide 2,2':6'-2''-terpyridine-4,4',4''-tricarboxylique)-(NCS)₃ et du Ru(4,4'-dicarboxy-2,2'-bipyridine)₂(CN)₂ ;
l'absorption du colorant composite (40) par la couche poreuse (30) ;
le positionnement de la seconde électrode (20) tournée vers la couche poreuse (40) sur la première électrode (10) ;
l'imprégnation d'un électrolyte (50) entre les première et seconde électrodes (10, 20) ; et
la fixation des première et seconde électrodes (10, 20) l'une à l'autre.

12. Procédé suivant la revendication 11, dans lequel le Ru(acide 2,2':6'-2"-terpyridine-4,4',4"-tricarboxylique)-(NCS)₃ est présent dans le colorant composite en une quantité allant d'environ 10 à environ 80 % en moles.

13. Procédé suivant la revendication 11, dans lequel l'étape de préparation d'un colorant composite (40) comprend la dissolution de Ru(acide 2,2':6'-2"-terpyridine-4,4',4"-tricarboxylique)(NCS)₃ dans un alcool à une concentration allant d'environ 0,1 à environ 5 mM, et ensuite l'addition d'une matière colorante différente à l'alcool.
